# EUROPEAN PATENT APPLICATION

(11) **EP 3 640 365 A1**
(43) Date of publication of application: **22.04.2020**
(21) Application number: 18912788.9
(22) Date of filing: 21.08.2018
(51) Int. Cl.: C23C 14/04, H01L 51/56

(54) **MASK PLATE AND PREPARATION METHOD THEREOF**

(30) Priority: 30.03.2018 CN 201810277643
(71) Applicant: Kunshan Go-Visionox Opto-Electronics Co., Ltd., Kunshan, Jiangsu 215300 (CN)
(72) Inventor: LI, Weili, Kunshan, Jiangsu 215300 (CN)
(74) Representative: D'Halleweyn, Nele Veerle Trees Gertrudis
(86) International application number: PCT/CN2018/101549
(87) International publication number: WO 2019/184205

(57) **Abstract**

The present application relates to a mask plate and a method of preparing the same, wherein the mask plate comprises a mask frame and a mask fixedly disposed on the mask frame. The mask is provided with a first region having a plurality of pixel openings for display, and a second region disposed around the first region and having a plurality of first auxiliary pixel openings. The first auxiliary pixel openings in the second region are in sizes smaller than the pixel openings in the first region. In the present application, by disposing the second region around the first region in the mask, and by making smaller sizes of the first auxiliary pixel openings in the second region than the pixel openings in the first region, the FMM from an unetched region to a fully etched region may have a strength between strengths of the unetched region and the fully etched region, thus causing a gradually changing stress that gradually reduces after the AA region (including the first region and the second region), and thereby preventing the AA area from damage to achieve the purpose of balancing the strength and uniformity of the FMM.

## Description

### TECHNICAL FIELD

The present application relates to the field of display technology, and more particularly, to a mask plate and a preparation method thereof.

### BACKGROUND

AM-OLED (active-matrix organic light emitting diode), which is called next-generation display technology, is favored because of advantages, such as low driving voltage, long life of light-emitting element, and the like. When full color is achieved in AMOLED by vapor deposition technology, FMM (fine metal mask) is required to ensure a position and a size of an organic material for vapor deposition.

However, procedures in vapor deposition, for example, magnetic matching and alignment of the chamber, and cleaning, transferring, and stretching a mask plate, and the like has high requirements on strength of the mask plate, and a poor strength may cause an easily damaged FMM in use. Moreover, based on a specific structure of FMM and the requirements on accuracy of a position for the vapor deposition, it is necessary to etch more material of FMM, especially FMM having a large-sized AA area (Active Area). A large amount of etching may cause FMM to be damaged during production and operation.

### SUMMARY

Based on this, the present application provides a mask plate and a preparation method thereof, which can balance the strength and uniformity of FMM.

The present application provides a mask plate comprising: a mask frame; and a mask fixedly disposed on the mask frame. The mask includes a first region having a plurality of pixel openings for display, and a second region positioned around the first region and having a plurality of first auxiliary pixel openings. The first auxiliary pixel openings in the second region are in sizes smaller than the pixel openings for display in the first region.

In an embodiment, the first auxiliary pixel openings in the second region are regularly arranged around the first region, and the sizes of the first auxiliary pixel openings regularly arranged around the first region generally decrease from the first region toward outside.

In an embodiment, the first auxiliary pixel openings in the second region are disposed around the first region as a plurality of circles of the first auxiliary pixel openings, the sizes of the plurality of circles of the first auxiliary pixel openings generally decrease from the first region toward outside circle by circle.

In an embodiment, the mask further includes a third region disposed between the first region and the second region, and the third region has a plurality of second auxiliary pixel openings.

In an embodiment, the second auxiliary pixel openings in the third region are in sizes same as the pixel openings for display in the first region.

In an embodiment, the second auxiliary pixel openings in the third region are in sizes smaller than the pixel openings for display in the first region, and the sizes of the second auxiliary pixel openings in the third region gradually decreases from the first region toward outside.

In an embodiment, the pixel openings in the first region are through holes, and the first auxiliary pixel openings in the second region are through holes or non-through holes.

In an embodiment, the second auxiliary pixel openings in the third region are through holes or non-through holes.

In an embodiment, the mask has a thickness gradually increasing from the first region toward outside.

The present application also provides a method for preparing a mask plate, comprising: providing a mask on which a plurality of pixel openings for display are etched to form a first region; etching a plurality of first auxiliary pixel openings around the first region to form a second region, the first auxiliary pixel openings in the second region are in sizes smaller than the pixel openings for display in the first region; and fixedly disposing the mask on a mask frame to form the mask plate.

In an embodiment, the first auxiliary pixel openings etched in the second region are regularly arranged around the first region, and the sizes of the first auxiliary pixel openings regularly arranged around the first region gradually decrease from the first region toward outside.

In an embodiment, the first auxiliary pixel openings in the second region are disposed around the first region as a plurality of circles of the first auxiliary pixel openings, and the sizes of the plurality of circles of the first auxiliary pixel openings gradually decrease from the first region toward outside circle by circle.

In an embodiment, the method further includes: etching a third region between the first region and the second region in the mask, and etching a plurality of second auxiliary pixel openings in the third region.

In an embodiment, the second auxiliary pixel openings in the third region are in sizes same the pixel openings for display in the first region.

In an embodiment, the second auxiliary pixel openings in the third region are in sizes smaller than the pixel openings for display in the first region, and the sizes of the second auxiliary pixel openings in the third region gradually decrease from the first region toward outside.

In an embodiment, the method further includes etching the mask to make the mask have a thickness gradually increasing from the first region toward outside.

According to the mask plate and the preparation method thereof, by disposing the second region around the first region in the mask, and by making smaller sizes of the first auxiliary pixel openings in the second region than the pixel openings in the first region, the FMM from an unetched region to a fully etched region may have a strength between strengths of the unetched region and the fully etched region, thus causing a gradually changing stress that gradually reduces after an AA region (including the first region and the second region), and thereby preventing the AA area from damage to achieve the purpose of balancing the strength and uniformity of the FMM.

### BRIEF DESCRIPTION OF THE DRAWINGS

FIG. 1 is a schematic structural view illustrating a mask plate according to an embodiment.
FIG. 2 is a partially enlarged schematic view illustrating a portion corresponding to a region C of FIG. 1 according to an embodiment.
FIG. 3 is a further detailed schematic view of FIG. 2.
FIG. 4 is a partially enlarged schematic view illustrating a portion corresponding to region C of FIG. 1 according to another embodiment.
FIG. 5 is a partial cross-sectional view taken along line X-X of FIG. 3.
FIG. 6 is a schematic flow chart of a method for preparing a mask plate according to an embodiment.

In the drawings, parts represented by each reference number is listed as follows: 100: mask plate;
11: mask frame;
12: mask;
121: first region;
122: pixel openings for display;
123: second region;
124: first auxiliary pixel openings;
1241: first circle of auxiliary pixel openings;
1242: second circle of auxiliary pixel openings;
125: third region;
126: second auxiliary pixel opening.

### DETAILED DESCRIPTION OF THE EMBODIMENTS

In order to make the objects, technical solutions and advantages of the present application clear, the present application will be further described in detail below with reference to the accompanying drawings and embodiments. It is understood that the specific embodiments described herein are merely illustrative of the application and are not intended to be limiting.

An embodiment of the present application provides a mask plate. It should be noted, the mask plate may be used to fabricate a display panel. The display panel may be an OLED (Organic Light-Emitting Diode) display panel or an AMOLED display panel. The mask plate may specifically be a fine metal mask (FMM). In this embodiment, an organic light-emitting layer in a display region of the display panel may be fabricated through the mask plate, and the organic light-emitting layer herein may be a light-emitting layer in the organic light-emitting diode for displaying an image in the display panel. Definitely, in other embodiments of the present application, other film layers in the organic display panel, such as an electron transport layer, an electron injection layer, a hole transport layer, a hole injection layer and the like, may also be fabricated by using the mask plate provided by the present application as needed.

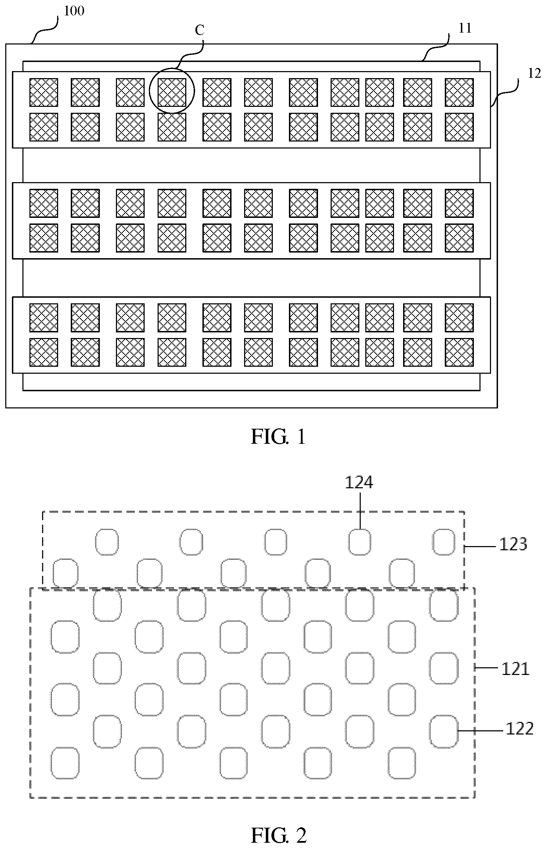

In an embodiment, as shown in FIG. 1, the mask plate 100 may include a mask frame 11 and a mask 12 fixedly disposed on the mask frame 11. The mask 12 may have a strip structure, and enables an organic light emitting material to be vapor-deposited onto a specified position corresponding to an array substrate or a position corresponding, one-to-one, to a pixel in the display area. The array substrate may be a TFT (Thin Film Transistor) substrate. In the embodiment, the mask 12 is provided with at least a region C corresponding to the array substrate (TFT substrate) or a region C corresponding, one-to-one, to the pixel in the display region.

FIG. 2 is a partially enlarged schematic view illustrating a portion corresponding to region C of FIG. 1. As shown in FIG. 2, the region C may be provided with a first region 121, and the first region 121 has a plurality of pixel openings 122 for display. Each of the pixel openings 122 in the mask 12 is an opening corresponding to each pixel electrode on the array substrate or an opening corresponding, one-to-one, to the pixel in the display region. Specifically, the organic light-emitting material may be vapor-deposited onto each anode through each of the pixel openings 122 to form an organic light-emitting layer on each anode.

In the embodiment, a second region 123 is further disposed around the first region 121 in the region C. FIG. 2 is a partial schematic view. It should be understood by those skilled in the art that the second region 123 is disposed around the first region 121; that is, the second region 123 may surround the first region 121. The second region 123 has a plurality of first auxiliary pixel openings 124. The first auxiliary pixel openings 124 may be formed by using a glass surface half-cutting form, thereby increasing a stretching strength of the mask. Specifically, the first auxiliary pixel openings 124 in the second region 123 are in sizes than the pixel openings 122 in the first region 121.

In the embodiment, by disposing the second region in the mask around the first region, and by making smaller sizes of the first auxiliary pixel openings in the second region than the pixel openings for display in the first region, the FMM from an unetched region to a fully etched region may have a strength between strengths of the unetched region and the fully etched region, thus causing a gradually changing stress that gradually reduces after an AA region (including the first region and the second region), and thereby preventing the AA area from damage to achieve the purpose of balancing the strength and uniformity of the FMM.

In an embodiment, in order to further balance the strength and uniformity of the FMM, the first auxiliary pixel openings 124 in the second region 123 may be regularly arranged around the first region 121. The first auxiliary pixel openings 124 may be arranged in a plurality of circles around the first region 121, and the sizes of the first auxiliary pixel openings 124 regularly arranged around the first region 121 decrease from the first region 121 toward outside circle by circle. That is, the sizes of the first auxiliary pixel openings 124 in the second region 123 are designed in a gradually changing form such that the sizes of the first auxiliary pixel openings 124 gradually decrease from the first region 121 toward outside, thereby gradually increasing the strength of the FMM.

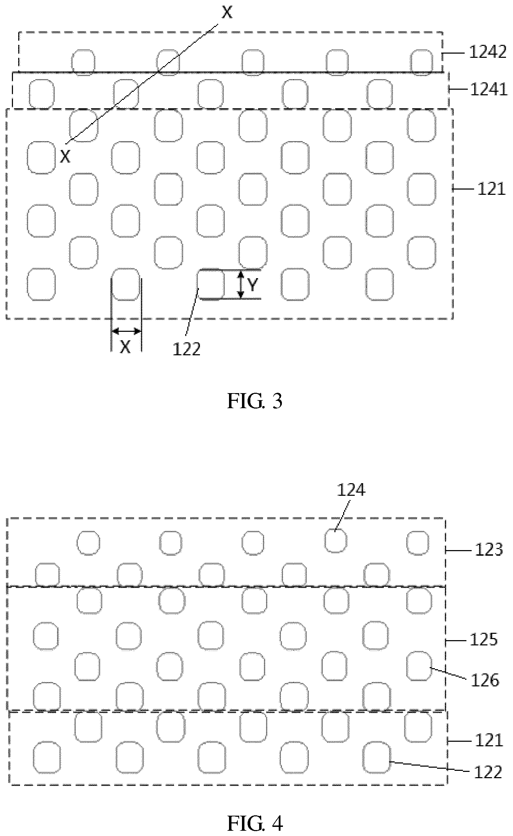

Specifically, in an embodiment, as shown in FIG. 3, it is assumed that two circle of the first auxiliary pixel openings are provided around the first region 121, i.e., as shown in FIG. 3, a first circle of auxiliary pixel openings 1241 and a second circle of auxiliary pixel openings 1242. The first circle of auxiliary pixel openings 1241 is close to the first region 121, and the pixel openings 122 in the first region 121 are in sizes larger than the first auxiliary pixel openings in the first circle of auxiliary pixel openings 1241, and the first auxiliary pixel openings in first circle of the auxiliary pixel openings 1241 are in sizes larger than the first auxiliary pixel openings in the second circle of auxiliary pixel openings 1242. Therefore, the sizes of the first auxiliary pixel openings decreases from the first region 121 toward outside circle by circle.

In the embodiment, it is assumed that the sizes of the pixel openings 122 in the first region 121 are set as X and Y, the sizes of the first auxiliary pixel openings of the first circle of auxiliary pixel openings 1241 close to the first region 121 may be set as (X-x1) and (Y-yl), and the sizes of the first auxiliary pixel openings of the second circle of auxiliary pixel openings 1242 may be set as (X-x1-x2) and (Y-y1-y2), wherein x1 and x2 are 10% of X, respectively, and y1 and y2 are 10% of Y, respectively. It should be noted that x1 and x2 may be 5%-40% of X, respectively, and may be different, and y1 and y2 may be 5%-40% of Y, respectively, and may be different. If a plurality of circles of first auxiliary pixel openings are provided around the first region 121, arrangement may analogically go on as long as the sizes of the first auxiliary pixel openings are guaranteed to gradually decrease from the first region 121 toward outside, thereby gradually increasing the strength of the FMM, and gradually changing the stress to prevent the mask from being damaged; and making a good uniformity of the entire FMM, and thus producing no large stretch and laminated wrinkle to meet design specification of a product.

In an embodiment, as shown in FIG. 4, the mask 12 may further include a third region 125 disposed between the first region 121 and the second region 123. The third region 125 has a plurality of second auxiliary pixel openings 126. In this embodiment, the second auxiliary pixel openings 126 in the third region 125 are in sizes same as the pixel opening 122 for display in the first region 121. Definitely, the sizes of the second auxiliary pixel openings 126 in the third region 125 may be different from the sizes of the pixel openings 122 for display in the first region 121. Specifically, the sizes of the second auxiliary pixel openings 126 in the third region 125 may be smaller than the sizes of the pixel openings 122 for display in the first region 121, and gradually decreases from the first region toward outside.

In addition, the pixel openings 122 for display in the first region 121 and the second auxiliary pixel openings 126 in the third region 125 may be through holes, and the first auxiliary pixel openings 124 in the second region 123 may be through holes or non-through holes. If the second auxiliary pixel openings 126 are non-through holes, they may be formed by using glass surface half-cutting form, and the first auxiliary pixel openings 124 in the second region 123 are designed in the form of the embodiment shown in FIG. 3. That is, the sizes of the first auxiliary pixel openings 124 in the second region 123 are designed in a gradually changing form. The first auxiliary pixel openings 124 in the second region 123 may also be designed as having sizes in a gradually changing form and etched to form through holes to increase its strength while maintaining the overall uniformity of the FMM.

In an embodiment, in order to further improve the strength and uniformity of the FMM, the mask 12 may also be etched such that the mask 12 has a thickness gradually increasing from the first region 121 toward outside, thereby increasing a thickness of the residual sheet. Therefore, the strength of the FMM gradually increases from the first region 121 toward outside, and thus the overall uniformity of the FMM is further improved due to a gradually changing strength of the FMM.

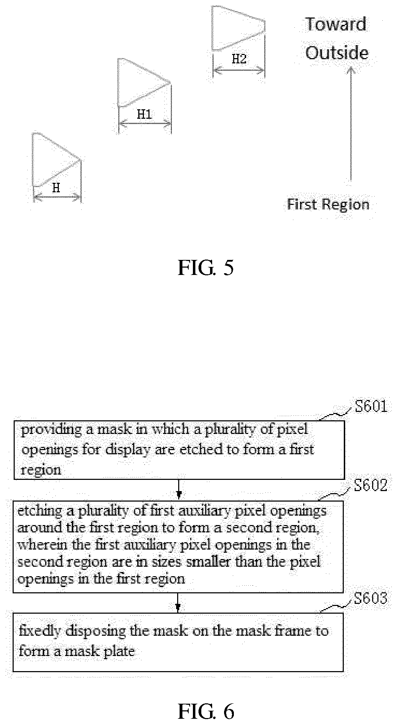

As shown in FIG. 5, it is assumed that after the mask is cut along the X-X line in FIG. 3, the first region 121 is measured for a thickness as H, the first circle of auxiliary pixel openings 1241 close to the first region 121 is measured for a thickness as HI, the second circle of auxiliary pixel openings 1242 disposed along the first circle of auxiliary pixel openings 1241 toward outside is measured for a thickness as H2, and H2>H1>H. Specifically, in the embodiment, the thickness of the first region 121, i.e. H, may be between 10 µm and 25 µm, and a maximal thickness of the mask, i.e., the thickness of an unetched region, does not exceed 30 µm. Under this condition, the strength and uniformity of the FMM may be further improved, and the risk of damage of the AA region in the FMM is greatly reduced, as long as the thickness of the mask is gradually increased from the first region 121 toward outside.

An embodiment of the present application further provides a method for preparing a mask plate. As shown in FIG. 6, the method may include:
in S601, providing a mask in which a plurality of pixel openings for display are etched to form a first region.

The mask may have a strip structure, and specifically, a metal material may be used, so that an organic light-emitting material may be vapor-deposited onto a specific position corresponding to an array substrate (TFT substrate) or a position corresponding, one-to-one, to the pixel in the display area. Each of the pixel openings in the mask is an opening corresponding to each pixel electrode on the array substrate or an opening corresponding, one-to-one, to the pixel in the display area, thereby vapor-depositing the organic light-emitting material onto each anode through each of the pixel openings to form an organic light-emitting layer on each anode
Step S602, etching a plurality of first auxiliary pixel openings around the first region to form a second region, the first auxiliary pixel openings in the second region are in sizes smaller than the pixel openings in the first region.

In the embodiment, the pixel openings in the first region are etched as through holes, the first auxiliary pixel openings in the second region may be formed in a glass surface half-cutting form, and are in sizes smaller than the pixel openings in the first region, thereby increasing the stretching strength of the mask.

Step S603, fixedly disposing the mask on the mask frame to form a mask plate.

The mask frame may also be made of a metal material. The mask plate is formed by fixedly disposing the mask on the mask frame, so that a display panel may be fabricated through the mask plate.

In the embodiment, by etching and forming the second region around the first region in the mask, and by making smaller sizes of the first auxiliary pixel openings in the second region than the pixel openings in the first region, the FMM from an unetched region to a fully etched region may have a gradually changing strength, thus causing a gradually changing stress that gradually reduces after an AA region (including the first region and the second region), and thereby preventing the AA area from damage to achieve the purpose of balancing the strength and uniformity of the FMM.

In an embodiment, the first auxiliary pixel openings etched in the second region are regularly arranged around the first region. The sizes of the first auxiliary pixel openings regularly arranged decrease from the first region toward outside circle by circle. Specifically, the first auxiliary pixel openings may be disposed in a plurality of circles around the first region, and the size of the first auxiliary pixel openings regularly arranged in a circle decreases from the first region toward outside. That is, the sizes of the first auxiliary pixel openings in the second region are designed in a gradually changing form such that the sizes of the first auxiliary pixel openings gradually decrease from the first region toward outside, and thereby the strength of the FMM is gradually increased.

In an embodiment, the mask further includes a third region disposed between the first region and the second region, wherein a plurality of second auxiliary pixel openings are etched in the third region. Specifically, the second auxiliary pixel openings in the third region are in sizes same as the pixel openings in the first region. A difference between the second auxiliary pixel openings in the third region and the pixel openings in the first region lies in that the pixel openings in the first region are through holes, and the second auxiliary pixel openings in the third region are non-through holes. That is, the second auxiliary pixel openings may be formed in a glass surface half- etching form. Design for the first auxiliary pixel openings in the second region can be performed in two methods: the first method is to design the first auxiliary pixel openings in the second region in the form of the above embodiment, i.e., in a gradually changing form; the other method is to design the same sizes of the first auxiliary pixel openings in the second region as the pixel openings in the first region, and the non-through holes may be formed by the glass surface half-cutting form to increase the strength while maintaining the overall uniformity of the FMM.

In an embodiment, in order to further increase the strength and uniformity of the FMM, the mask may also be etched such that the thickness of the mask gradually increases from the first region toward outside, thereby increasing the thickness of a residual sheet. Therefore, the strength of the FMM gradually increases from the first region toward outside, and the overall uniformity of the FMM is further improved due to a gradually changing strength of the FMM.

The technical features of the above embodiments may be arbitrarily combined. For the sake of brevity of description, not all possible combinations of the respective technical features in the above embodiments are described. However, the combination of these technical features should be considered within the range described in this specification as long as they have no collision with each other.

The above-mentioned embodiments are merely illustrative of several embodiments of the present application, and the description thereof is more specific and detailed, but is not to be construed as limiting the scope of the present disclosure. It should be noted that a number of variations and modifications may be made by those skilled in the art without departing from the spirit and scope of the present application. Therefore, the scope of the invention should be determined by the appended claims.

## Claims

1. A mask plate, comprising:
a mask frame; and
a mask fixedly disposed on the mask frame,
the mask includes a first region having a plurality of pixel openings for display, and a second region positioned around the first region and having a plurality of first auxiliary pixel openings, and the first auxiliary pixel openings in the second region are in sizes smaller than the pixel openings for display in the first region.

2. The mask plate of claim 1, wherein the first auxiliary pixel openings in the second region are regularly arranged around the first region, and the sizes of the first auxiliary pixel openings regularly arranged around the first region generally decrease from the first region toward outside.

3. The mask plate of claim 1, wherein the first auxiliary pixel openings in the second region are disposed around the first region as a plurality of circles of the first auxiliary pixel openings, the sizes of the plurality of circles of the first auxiliary pixel openings generally decrease from the first region toward outside circle by circle.

4. The mask plate of claim 1, wherein the mask further includes a third region disposed between the first region and the second region, and the third region has a plurality of second auxiliary pixel openings.

5. The mask plate of claim 4, wherein the second auxiliary pixel openings in the third region are in sizes same as the pixel openings for display in the first region.

6. The mask plate of claim 4, wherein the second auxiliary pixel openings in the third region are in sizes smaller than the pixel openings for display in the first region, and the sizes of the second auxiliary pixel openings in the third region gradually decrease from the first region toward outside.

7. The mask plate of claim 1, wherein the pixel openings in the first region are through holes, and the first auxiliary pixel openings in the second region are through holes or non-through holes.

8. The mask plate of claim 4, wherein the second auxiliary pixel openings in the third region are through holes or non-through holes.

9. The mask of any of claims 1-8, wherein the mask has a thickness gradually increasing from the first region toward outside.

10. A method for preparing a mask plate, comprises:
providing a mask on which a plurality of pixel openings for display are etched to form a first region;
etching a plurality of first auxiliary pixel openings around the first region to form a second region, the first auxiliary pixel openings in the second region being in sizessmaller than the pixel openings for display in the first region; and
fixedly disposing the mask on a mask frame to form the mask plate.

11. The method of claim 10, wherein the first auxiliary pixel openings etched in the second region are regularly arranged around the first region, and the sizes of the first auxiliary pixel openings regularly arranged around the first region gradually decrease from the first region toward outside.

12. The method of claim 10, wherein the first auxiliary pixel openings in the second region are disposed around the first region as a plurality of circles of the first auxiliary pixel openings, and the sizes of the plurality of circles of the first auxiliary pixel openings gradually decrease from the first region toward outside circle by circle.

13. The method of claim 10, wherein the method further comprises: etching a third region between the first region and the second region in the mask, and etching a plurality of second auxiliary pixel openings in the third region.

14. The mask plate of claim 13, wherein the second auxiliary pixel openings in the third region are in sizes same as the pixel openings for display in the first region.

15. The mask plate of claim 13, wherein the second auxiliary pixel openings in the third region are in sizes smaller than the pixel openings for display in the first region, and the sizes of the second auxiliary pixel openings in the third region gradually decreases from the first region toward outside.

16. The method of any one of claims 10-15, wherein the method further comprises etching the mask to make the mask have a thickness gradually increasing from the first region toward outside.
